# EUROPEAN PATENT SPECIFICATION

(11) **EP 2 952 821 B1**
(45) Date of publication and mention of the grant of the patent: **10.07.2019**
(21) Application number: 14745818.6
(22) Date of filing: 21.01.2014
(51) Int. Cl.: F24F 1/24, F24F 1/18, H05K 7/20

(54) **METHOD FOR MANUFACTURING AN OUTDOOR UNIT**
VERFAHREN ZUM HERSTELLUNG EINER AUSSENEINHEIT
PROCÉDÉ DE FABRICATION D'UNE UNITÉ EXTÉRIEURE

(30) Priority: 01.02.2013 JP 2013018673
(43) Date of publication of application: 09.12.2015
(73) Proprietor: Mitsubishi Electric Corporation, Tokyo 100-8310 (JP)
(72) Inventor: UEHARA, Nobuaki, Tokyo 100-8310 (JP)
(74) Representative: Pfenning, Meinig & Partner mbB
(86) International application number: PCT/JP2014/051155
(87) International publication number: WO 2014/119430

(56) References cited:
- WO-A1-2013/098872
- JP-A- 2000 234 883
- JP-A- 2005 331 141
- JP-A- 2005 331 141
- JP-A- 2006 336 935
- JP-A- 2010 286 187
- JP-A- 2011 064 403

## Description

### Technical Field

The present invention relates to an outdoor unit for an air-conditioning apparatus using a fin-and-tube heat exchanger. In particular, the present invention relates to a cooling structure of an electric component installed in an outdoor unit.

### Background Art

An outdoor unit for an air-conditioning apparatus includes various electric components (electric parts) such as an inverter circuit for variably controlling the rotation speed of, for example, a compressor or a fan. Some electric components generate heat because of a flow of large current, for example. A high temperature may cause damage to the electric components, unstable driving, and other problems, which lead to reduced reliability of the outdoor unit. To prevent this, such electric components are cooled in order to prevent the electric components from reaching high temperatures.

In some cooling structures in electric components of outdoor units for air-conditioning apparatuses, for example, a cooling member is placed in an air passage of a heat exchanger and removes heat from the electric components so that the electric components are cooled (see, for example, Patent Literature 1). In the cooling structure, to increase the flow rate of air flowing in the cooling member, the heat exchanger is configured such that the distance between heat transmission fins of the heat exchanger in a position where the heat exchanger is located close to the cooling member is larger than other positions therein.

### Citation List

### Patent Literature

Patent Literature 1: Japanese Unexamined Patent Application Publication No. 2005-331141

JP 2005 331141A discloses that a heat radiating side 87 of the heat pipe 8 is positioned in an air trunk formed by a cooling fan 4. Further a heat radiating fin 7 is mounted at the heat radiating side 87 of the heat pipe 8, and a clearance of the cooling fans of a heat exchanger 5 in a range corresponding to the heat radiating fin 7 is wider than that of the other range.

JP 2000 234883A discloses inserting the pipes to the fins aligned with predetermined distance in between, and then, fixing the pipes and the fins by brazing.

### Summary of Invention

### Technical Problem

In such an outdoor unit for an air-conditioning apparatus as described in Patent Literature 1, a plurality of molds are needed for preparing heat transmission fins in order for the apparatus to have different distances between the heat transmission fins. This disadvantageously increases the manufacturing cost.

It is therefore an object of the present invention to provide, for example, a method for manufacturing an outdoor unit that can maintain the cooling effect of electric components with reduced cost.

### Solution to Problem

The present invention is as defined in the appended independent claim. Further implementations are disclosed in the appended dependent claims, the description and the figures.
An outdoor unit according to the present invention includes: a heat exchanger including heat transmission fins and heat transmission pipes, the heat transmission fins being spaced from one another with a distance, fitted to and fixed to the heat transmission pipes, so that heat is exchanged between refrigerant passing through the heat transmission pipes and air passing between the heat transmission fins; an electric component including a part of an electric system that controls equipment; and a cooling member disposed in a channel of air passing through the heat exchanger, the cooling member configured to dissipate heat from the electric component to the air, wherein the heat transmission fins are fitted to the heat transmission pipes such that the distance between the heat transmission fins is configured to be larger, in a position corresponding to a position where the cooling member is located and that serves as a passage of the air passing through the cooling member, than in other positions in the heat exchanger.

### Advantageous Effects of Invention

According to the present invention, the cooling member is disposed in the channel of air passing through the heat exchanger so as to cool an electric component. Thus, the electric component can be efficiently cooled. In the cooling, the heat transmission fins are fitted to the heat transmission pipes with increased distances therebetween in a position corresponding to the location of the cooling member. This configuration makes it possible to provide, at low cost, an outdoor unit including a heat exchanger in which air resistance caused by the heat transmission fins can be reduced so that a large amount of air is allowed to pass through the cooling member in order to maintain the cooling effect.

### Brief Description of Drawings

Fig. 1 is an illustration (a first illustration) of, for example, a configuration of an outdoor unit 10 according to Embodiment 1 of the present invention.
Fig. 2 is an illustration (a second illustration) of, for example, the configuration of the outdoor unit 10 according to Embodiment 1 of the present invention.
Fig. 3 is an illustration (a first illustration) of an arrangement of, for example, an electric component chamber 30 according to Embodiment 1 of the present invention.
Fig. 4 is an illustration (a second illustration) of the arrangement of, for example, the electric component chamber 30 according to Embodiment 1 of the present invention.
Fig. 5 illustrates a heat exchanger 20 according to Embodiment 1 of the present invention in detail.
Fig. 6 illustrates a configuration of an air-conditioning apparatus.

### Description of Embodiments

### Embodiment 1

Embodiment 1 of the present invention will be described hereinafter.

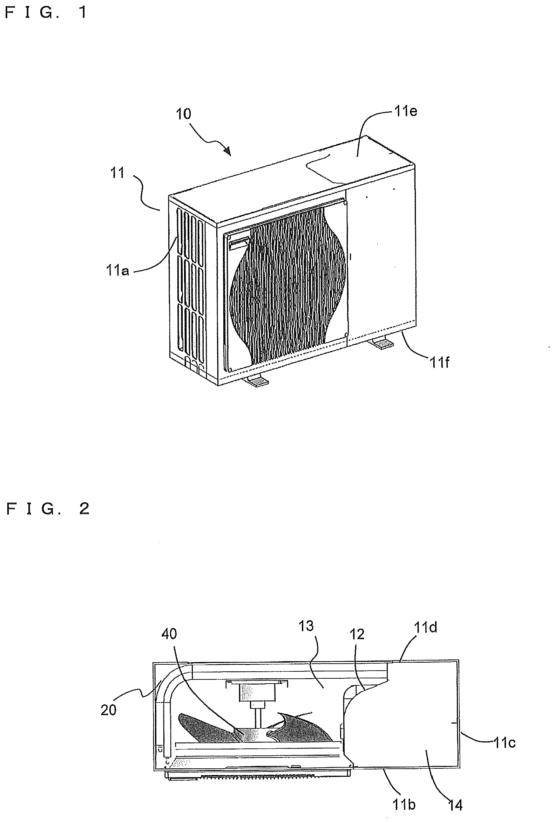

Figs. 1 and 2 illustrate a configuration of an outdoor unit 10 according to Embodiment 1 of the present invention, for example. Fig. 1 is a perspective view of the outdoor unit 10 when viewed from an air outlet. Fig. 2 is an illustration for describing the internal configuration of the outdoor unit 10 when viewed from above.

The outdoor unit 10 has a body 11 including a casing having two side surfaces 11a and 11c, a front surface 11b, a rear surface 11d, an upper surface 11 e, and a bottom surface 11f. The side surface 11a and the rear surface 11d have openings through which air is taken in from the outside. The front surface 11b has an opening serving as an air outlet through which air blows out to the outside. The air outlet is covered with a fan grille in order to prevent contact
between an object or the like and a blower device 40 for safety.

The body 11 includes at least a heat exchanger 20, an electric component chamber 30, a cooling member 32, and a blower device 40. The blower device 40 includes, for example, a propeller fan in which a plurality of vanes are disposed around a propeller boss. A fan motor disposed near the rear surface of the propeller fan is driven to rotate and creates an air flow in which air in the outside (outdoor air) passes through the heat exchanger 20. The inside of the body 1 is partitioned by a partition plate 12 into a blower device chamber 13 in which the blower device 40 is disposed and a machinery chamber 14 in which the compressor and an electric component 31, for example, are disposed.

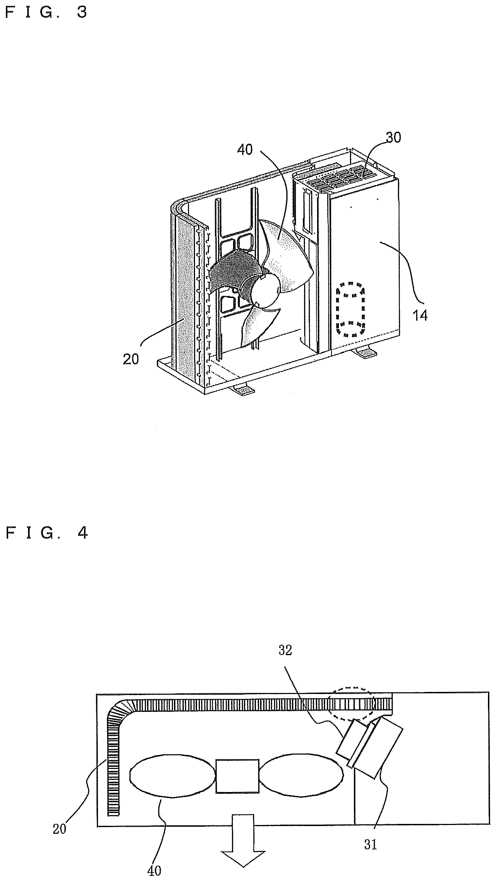

Figs. 3 and 4 illustrate an arrangement of the electric component chamber 30 and other components in Embodiment 1 of the present invention. As illustrated in Fig. 3, the machinery chamber 14 further includes an electric component chamber 30, and the electric component chamber 30 accommodates the electric component 31. The electric component 31 is, for example, an electric circuit that performs control for, for example, driving equipment (an actuator) such as the compressor in the outdoor unit 10. The cooling member 32 is a member such as a comb-shaped heat sink that takes away (receives) heat generated by the electric component 31 in the electric component chamber 30 and rejects heat. As illustrated in Fig. 4, the cooling member 32 of Embodiment 1 is disposed at a location in an air passage through which air is caused to pass by driving the blower device 40.

The heat exchanger 20 is formed in an L shape by bending and is designed such that air flows in two directions from the side surface 11a and the rear surface 11d, respectively. When used in an air-conditioning apparatus, for example, the heat exchanger 20 serves as a condenser for condensing refrigerant in a cooling operation and serves as an evaporator for evaporating refrigerant in a heating operation. As will be described later, the heat exchanger 20 of Embodiment 1 includes heat transmission fins 21 and heat transmission pipes 22 and exchanges heat between the refrigerant and air outside the room (outdoor air). Each of the heat transmission fins 21 and the heat transmission pipes 22 is made of aluminum or an aluminum alloy. The use of, for example, aluminum can enhance the heat exchange efficiency and reduce the weight and size of the heat exchanger. The heat transmission fins 21 of Embodiment 1 are flat-plate (rectangular) fins. The heat transmission pipes 22 are flat tubes that are flat-shaped heat transmission pipes partially curved in cross section.

The heat transmission fins 21 serve as a resistance to air passing through the heat exchanger 20. Thus, the heat transmission fins 21 are obstacles in supplying air in order to facilitate heat dissipation of the cooling member 32. In view of this, as illustrated in Fig. 4, the heat exchanger 20 of Embodiment 1 is configured such that the distance between the heat transmission fins 21 is increased in a position (a position close to the cooling member 32) of the heat exchanger 20 so as to obtain a sufficiently large air passage for the cooling member 32. Since the distance is partially increased, the efficiency of the cooling member 32 can be increased without a significant decrease in the area of the heat transmission fins 21 in the entire heat exchanger 20.

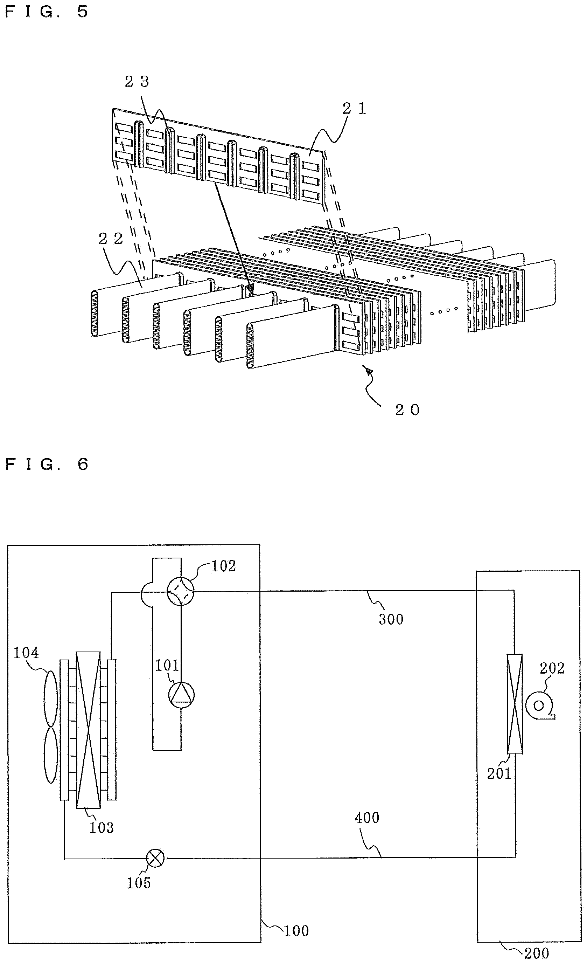

Fig. 5 illustrates the heat exchanger 20 of Embodiment 1 of the present invention in detail. As illustrated in Fig. 5, in the heat exchanger 20 of Embodiment 1, the heat transmission pipes 22 are arranged with predetermined distances and fixed in, for example, a dedicated device. The direction in which the heat transmission pipes 22 are arranged side by side is orthogonal to the channel direction of the refrigerant flowing in the pipes.

As also illustrated in Fig. 5, the heat transmission fins 21 include a plurality of insertion cutouts 23 arranged in the longitudinal direction (i.e., the direction in which the heat transmission pipes 22 are arranged side by side). Each of the insertion cutouts has one open end on one of the longitudinal edges of a corresponding of the heat transmission fins 21, so that the heat transmission pipes 22 can be fitted to the heat transmission fins 21. That is, the heat transmission fins 21 have comb-like shapes. In conformity with the arrangement of the heat transmission pipes 22, the number of the insertion cutouts 23 is equal to that of the heat transmission pipes 22, and the insertion cutouts 23 are arranged with the same distances therebetween as those between the heat transmission pipes 22 (except both ends), for example. In addition, the heat transmission fins 21 are fitted to and fixed to the heat transmission pipes 22 such that the heat transmission fins 21 are parallel to one another in the refrigerant channel direction (i.e., the direction orthogonal to the direction in which the heat transmission pipes 22 are arranged side by side). Slits formed by cutting and raising part of the heat transmission fins 21 may be, but are not limited to being, provided between the insertion cutouts 23. Fin collars may be formed so as to stand vertically on the heat transmission fins 21 at the rims of the insertion cutouts 23.

Portions (brazed portions) in which the heat transmission fins 21 are in contact with the heat transmission pipes 22 are joined by brazing, thereby fabricating the heat exchanger 20. This fabrication enables the heat transmission fins 21 to be fitted to the heat transmission pipes 22 with desired distances therebetween. Thus, the configuration in which the distance between the heat transmission fins 21 varies in the single heat exchanger 20 can be obtained at a relatively low cost.

As described above, the outdoor unit 10 of Embodiment 1 includes the cooling member 32 for cooling the electric component 31 in the air passage of air flow formed when driving the blower device 40 in the blower device chamber 13. Thus, the electric component 31 can be efficiently cooled. As a result, reliability can be enhanced. In addition, the heat exchanger 20 is configured such that the heat transmission fins 21 are fitted to and fixed to the heat transmission pipes 22. Thus, in fabrication, insertion can be easily performed with wide distances between the heat transmission fins 21 serving as a channel of air that is in contact with the cooling member 32. Thus, both enhancement of cooling efficiency of the electric component 31 and maintenance of efficiency of the heat exchanger 20 can be achieved at a relatively low cost.

Fig. 6 illustrates a configuration of an air-conditioning apparatus. A refrigeration cycle apparatus using the above-described outdoor unit 10 as an outdoor unit 100 will be described. Here, the air-conditioning apparatus will be described as a typical example of a refrigeration cycle apparatus. The air-conditioning apparatus illustrated in Fig. 6 includes the outdoor unit 100 and an indoor unit 200 that are connected to each other by refrigerant pipes so that refrigerant circulates therein. Among the refrigerant pipes, a pipe in which a gas refrigerant flows will be referred to as a gas pipe 300 and a pipe in which a liquid refrigerant
(which may be a two-phase gas-liquid refrigerant) flows will be referred to as a liquid pipe 400.

The outdoor unit 100 includes a compressor 101, a four-way valve 102, an outdoor-side heat exchanger 103, an outdoor-side blower device 104, and an expansion device (an expansion valve) 105.

The compressor 101 compresses a sucked refrigerant and discharges the compressed refrigerant. Here, the presence of, for example, an inverter as an electric component 31 can change the operating frequency of the compressor 101 as intended so that the capacity (the amount of the refrigerant that is sent from the compressor 101 in a unit time) of the compressor 101 can be minutely changed. On the basis of an instruction from a control device (not shown), the four-way valve 102 switches a flow of the refrigerant between a cooling operation and a heating operation.

The outdoor-side heat exchanger 103 constituted by the heat exchanger 20 described above exchanges heat between refrigerant and air (outdoor air). Specifically, in the heating operation, the outdoor-side heat exchanger 103 serves as an evaporator that exchanges heat between a low-pressure refrigerant from the liquid pipe 400 and air, evaporates the refrigerant, and vaporizes the refrigerant. In the cooling operation, the outdoor-side heat exchanger 103 serves as a condenser that exchanges heat between refrigerant that has flowed from the four-way valve 102 and that has been compressed in the compressor 101 and air, condenses the refrigerant, and liquefies the refrigerant. An outdoor-side blower device 104 that is the above-described blower device 40 is provided. The outdoor-side blower device 104 may also be configured such that
the inverter as the electric component 31 can change the operating frequency of the fan motor as intended so as to minutely change the rotation speed. The expansion device 105 changes its opening degree so as to adjust the pressure of the refrigerant, for example.

On the other hand, the indoor unit 200 includes a load-side heat exchanger 201 and a load-side blower device 202. The load-side heat exchanger 201 exchanges heat between refrigerant and air. Specifically, in the heating operation, the load-side heat exchanger 201 serves as a condenser that exchanges heat between refrigerant from the gas pipe 300 and air, condenses the refrigerant, liquefies the condensed refrigerant (or changes the refrigerant into a two-phase gas-liquid refrigerant), and causes the refrigerant to flow out toward the liquid pipe 400. On the other hand, in the cooling operation, the load-side heat exchanger 201 serves as an evaporator that exchanges heat between refrigerant that has changed into a low-pressure state by the expansion device 105, for example, and air, causes the refrigerant to receive heat from the air, evaporates and vaporizes the refrigerant, and causes the resulting refrigerant to flow out toward the gas pipe 300. The indoor unit 200 also includes a load-side blower device 202 for adjusting the flow of air for use in the heat exchange. The operation speed of the load-side blower device 202 can be set by, for example, a user.

Here, the above-described refrigeration cycle apparatus can use HCFC (R22), HFC (e.g., R116, R125, R134a, R14, R143a, R152a, R227ea, R23, R236ea, R236fa, R245ca, R245fa, R32, R41, RC318, or a refrigerant mixture of some of these refrigerants, such as R407A, R407B, R407C, R407D, R407E, R410A, R410B, R404A, R507A, R508A, or R508B), HC (e.g., butane, isobutane, ethane, propane, propylene, or a refrigerant mixture of some of these refrigerants), a natural refrigerant (e.g., air, carbon dioxide, ammonia, or a refrigerant mixture of some of these refrigerant substances), a low-GWP refrigerant such as HFO1234yf, or a refrigerant mixture of some of these refrigerants.

Irrespective of the solubility of a refrigerant and oil, the above-described advantages can be obtained by using any types of refrigerating machine oil such as mineral oil-based refrigerating machine oil, alkylbenzene oil-based refrigerating machine oil, ester oil-based refrigerating machine oil, ether oil-based refrigerating machine oil, or fluorine oil-based refrigerating machine oil.

Similar advantages can also be obtained in a case where the heat exchanger 20 of Embodiment 1 is used in the load-side heat exchanger 201 of the indoor unit 200.

As described above, in the refrigeration cycle apparatus of figure 6, the heat exchanger 20 of Embodiment 1 is used as the outdoor-side heat exchanger 103. Thus, the electric component 31 can be efficiently cooled, thereby enhancing the reliability of the apparatus.

### Industrial Applicability

The present invention is widely applicable to outdoor units constituting refrigeration cycle apparatuses, such as an outdoor unit of an air-conditioning apparatus or a hot water supply, and other apparatuses and equipment.

### Reference Signs List

10 outdoor unit, 11 body, 11a, 11c side surface, 11b front surface, 11d rear surface, 11e upper surface, 11f bottom surface, 12 partition plate, 13 blower device chamber, 14 machinery chamber, 20 heat exchanger, 21 heat transmission fin, 22 heat transmission pipe, 23 insertion cutout, 30 electric component chamber, 31 electric component, 32 cooling member, 40 blower device, 100 outdoor unit, 101 compressor, 102 four-way valve, 103 outdoor-side heat exchanger, 104 outdoor-side blower device, 105 expansion device, 200 indoor unit, 201 load-side heat exchanger, 202 load-side blower device, 300 gas pipe, 400 liquid pipe.

## Claims

1. A method for manufacturing an outdoor unit (100) for an air conditioning apparatus, the outdoor unit having:
a heat exchanger (20) including heat transmission fins (21) and heat transmission pipes (22), the heat transmission fins (21) being spaced from one another with a distance, fitted to and fixed to the heat transmission pipes (22), so that heat is exchanged between refrigerant passing through the heat transmission pipes (22) and air passing between the heat transmission fins (21);
an electric component (31) including a part of an electric system that controls equipment; and
a cooling member (32) disposed in a channel of air passing through the heat exchanger (20), the cooling member (32) configured to dissipate heat from the electric component (31) to the air, the method comprising:
fixing the heat transmission pipes (22) arranged with a predetermined distances in between, in a dedicated device;
inserting, after fixing the heat transmission pipes (22), the heat transmission fins (21) to the fixed heat transmission pipes (22), the distance between the heat transmission fins (21) being configured to be larger, in a position corresponding to a position where the cooling member (32) is located and that serves as a passage of the air passing through the cooling member (32), than in other positions in the heat exchanger (20); and
joining the heat transmission pipes (22) and the heat transmission fins (21) by brazing;
wherein
the heat transmission fins (21) have insertion cutouts (23) having a shape conforming to a shape of the heat transmission pipes (22), and
the heat transmission fins (21) are fitted to the heat transmission pipes (22) through the insertion cutouts (23).

2. The method for manufacturing an outdoor unit (100) of claim 1, wherein the heat transmission pipes (22) are flat tubes.

## Patentansprüche

1. Verfahren zum Herstellen einer Außeneinheit (100) für eine Klimaanlage, wobei die Außeneinheit aufweist:
einen Wärmetauscher (20), aufweisend Wärmeübertragungsrippen (21) und Wärmeübertragungsleitungen (22), wobei die Wärmeübertragungsrippen (21) mit einem Abstand voneinander beabstandet sind, an die Wärmeübertragungsleitungen (22) angebracht und daran befestigt sind, so dass Wärme zwischen Kältemittel, das durch die Wärmeübertragungsleitungen (22) durchströmt, und Luft, die zwischen den Wärmeübertragungsrippen (21) hindurch strömt, ausgetauscht wird;
eine elektrische Komponente (31), aufweisend einen Teil eines elektrischen Systems, das Ausrüstung steuert; und
ein Kühlelement (32), das in einem Kanal der Luft, die durch den Wärmetauscher (20) durchströmt, angeordnet ist, wobei das Kühlelement (32) eingerichtet ist, Wärme von der elektrischen Komponente (31) an die Luft abzuleiten, wobei das Verfahren umfasst:
Befestigen der Wärmeübertragungsleitungen (22), die mit vorherbestimmten Abständen dazwischen angeordnet sind, in einer zugeordneten Vorrichtung;
Einsetzen, nach Befestigen der Wärmeübertragungsleitungen (22), der Wärmeübertragungsrippen (21) an den befestigten Wärmeübertragungsleitungen (22), wobei der Abstand zwischen den Wärmeübertragungsrippen (21) eingerichtet ist, größer zu sein in einer Position entsprechend einer Position, wo sich das Kühlelement (32) befindet und die als ein Durchlass der Luft dient, die durch das Kühlelement (32) durchströmt, als in anderen Positionen im Wärmetauscher (20); und
Verbinden der Wärmeübertragungsleitungen (22) und der Wärmeübertragungsrippen (21) durch Löten;
wobei
die Wärmeübertragungsrippen (21) Einsetzaussparungen (23) aufweisen, die eine mit einer Form der Wärmeübertragungsleitungen (22) übereinstimmende Form aufweisen, und
die Wärmeübertragungsrippen (21) an den Wärmeübertragungsleitungen durch die Einsetzaussparungen (23) angebracht sind.

2. Verfahren zum Herstellen einer Außeneinheit (100) nach Anspruch 1, wobei die Wärmeübertragungsleitungen (22) Flachrohre sind.

## Revendications

1. Procédé de fabrication d'une unité extérieure (100) d'un appareil de climatisation, l'unité extérieure présentant :
un échangeur de chaleur (20) comprenant des ailettes de transmission de la chaleur (21) et des canalisations de transmission de la chaleur (22), les ailettes de transmission de la chaleur (21) étant espacées les unes des autres d'une distance, ajustées et fixées sur les canalisations de transmission de la chaleur (22), de sorte que la chaleur soit échangée entre un fluide frigorigène circulant dans les canalisations de transmission de la chaleur (22) et l'air passant entre les ailettes de transmission de la chaleur (21) ;
un composant électrique (31) comprenant une partie d'un système électrique qui commande un matériel ; et
un élément de refroidissement (32) disposé dans un canal d'air passant à travers l'échangeur de chaleur (20), l'élément de refroidissement (32) étant configuré pour dissiper dans l'air la chaleur en provenance du composant électrique (31), le procédé comprenant les étapes suivantes :
fixer les canalisations de transmission de la chaleur (22) agencées avec des distances prédéterminées entre elles, dans un dispositif dédié ;
après avoir fixé les canalisations de transmission de la chaleur (22), insérer les ailettes de transmission de la chaleur (21) sur les canalisations de transmission de la chaleur (22), la distance entre les ailettes de transmission de la chaleur (21) étant configurée pour être plus grande, à une position correspondant à une position où se situe l'élément de refroidissement (32) et qui sert de passage à l'air passant à travers l'élément de refroidissement (32), qu'à d'autres positions dans l'échangeur de chaleur (20) ; et
joindre par brasage les canalisations de transmission de la chaleur (22) et les ailettes de transmission de la chaleur (21) ;
où
les ailettes de transmission de la chaleur (21) présentent des découpes d'insertion (23) présentant une forme correspondant à la forme des canalisations de transmission de la chaleur (22), et
les ailettes de transmission de la chaleur (21) sont ajustées sur les canalisations de transmission de la chaleur (22) à travers les découpes d'insertion (23).

2. Procédé de fabrication d'une unité extérieure (100) selon la revendication 1, où les canalisations de transmission de la chaleur (22) sont des tubes plats.
